# EUROPEAN PATENT SPECIFICATION

(11) **EP 4 422 071 B1**
(45) Date of publication and mention of the grant of the patent: **11.03.2026**
(21) Application number: 24163581.2
(22) Date of filing: 14.03.2024
(51) Int. Cl.: H03K 3/356, H03K 5/24

(54) **CIRCUIT WITH A LATCH HAVING SETS OF INVERTERS**
SCHALTUNG MIT EINEM LATCH MIT SÄTZEN VON INVERTERN
CIRCUIT AVEC BASCULE AYANT DES ENSEMBLES D'INVERSEURS

(43) Date of publication of application: 28.08.2024
(73) Proprietor: NXP B.V., 5656 AG Eindhoven (NL)
(72) Inventor: Cents, Remon Bernardus Antonius, 5656AG Eindhoven (NL); Ponte, Jeroen, 5656AG Eindhoven (NL); Bindra, Harijot Singh, 5656AG Eindhoven (NL); Nauta, Bram, 5656AG Eindhoven (NL)
(74) Representative: Hardingham, Christopher Mark

(56) References cited:
- US-A1- 2021 175 877
- US-B2- 8 487 802
- YI-CHENG CHEN ET AL: "A 6Bit 3GS/s two-channel time interleaved interpolating flash ADC", 2013 IEEE INTERNATIONAL CONFERENCE OF ELECTRON DEVICES AND SOLID-STATE CIRCUITS, IEEE, 3 June 2013 (2013-06-03), pages 1 - 4, XP032502557, DOI: 10.1109/EDSSC.2013.6628099

## Description

### BACKGROUND OF THE INVENTION

### Field of the Invention

This invention relates to a circuit with a latch having inverters.

### Background

Latches are used in circuits to store at least momentarily a data state for further utilization. For example, latches can be used in circuits such as comparison circuits to momentarily store the final comparison result.

US 2021/175877 A1 discloses a storage comparison circuit device comprising a latch and a comparator. The latch is configured to latch inputted first input data and output first output data and second output data. The first output data are the same as the first input data, whereas the second output data are different from the first input data, wherein the first output data and the second output data are respectively inputted into the comparator. The comparator is configured to receive second input data, the first output data and the second output data, and to output a comparison result.

### BRIEF DESCRIPTION OF THE DRAWINGS

The present invention may be better understood, and its numerous objects, features, and advantages made apparent to those skilled in the art by referencing the accompanying drawings.
Figure 1 is a circuit diagram of a comparison circuit including a latch according to one embodiment of the present invention.
Figure 2 is a timing diagram of the circuit of Figure 1 according to one embodiment of the present invention.
Figure 3 is a circuit diagram of a latch according to one embodiment of the present invention.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

Disclosed herein is latch that includes two outputs and two inputs where the outputs latch complementary values indicative of voltages at the latch inputs. The latch includes two sets of one or more inverters each coupled in a signal series path. For each set of inverters, the signal input of the first in series inverter is connected to a latch input and the output of the last in series inverter is connected to a latch output. The first in series inverters for each set of one or more inverters has a signal input connected to one latch input and a supply voltage input configured to be biased by the other latch input. During a reset phase, the latch outputs are configured to be set to the same output value state. During a latching phase, the latch outputs are configured to be latched at complementary output value states dependent upon voltages of the first input and the second input. In some embodiments, the latch is used in a comparison circuit, where the outputs indicate a result of a comparison of two inputs of the comparison circuit.

One advantage of providing a latch wherein the first in series inverters have a signal input connected to one of the latch inputs and a supply input coupled to the other latch input is that in some embodiments, the latch changes the state of an output value based on the voltage differential of the two latch inputs passing a particular threshold voltage, thereby allowing for a faster transmission over a latch where the supply input the first in series inverter is coupled to be biased by a supply voltage. Furthermore, during a reset phase, setting the latch outputs to the same output value may be advantageous to provide synchronization for the output data and to avoid inter-symbol interference from previous circuitry that generated the latch input signals.

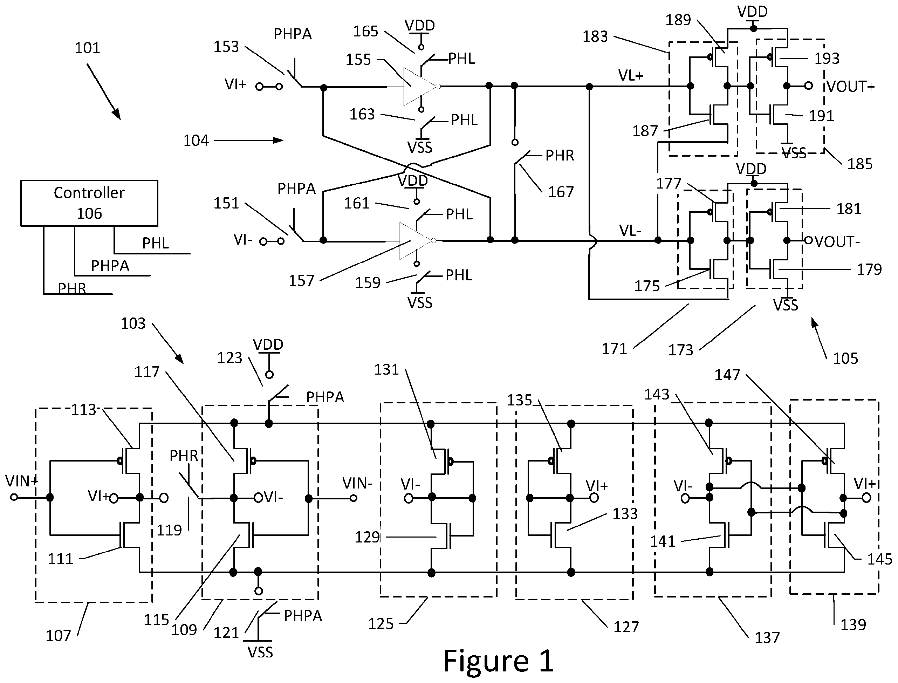

Figure 1 is a circuit diagram of a comparison circuit according to one embodiment of the present invention. Comparison circuit 101 includes a pre-amplifier 103, a latch 104, and a latch 105. The outputs of latch 105 (VOUT+, VOUT-) provide a latched differential indication of a voltage difference between the inputs of pre-amplifier 103 (VIN+, VIN-). In the embodiment shown, comparison circuit 101 operates in three phases: a reset phase, a pre-amplification phase, and a latch phase.

Pre-amplifier 103 includes two inputs (VIN+, VIN-). VIN+ is connected to the signal input of inverter 107 which includes a P-type field effect transistor (PFET) 113 and an N-type field effect transistor (NFET) 111. The signal output of inverter 107 is connected to pre-amplifier output VI+. VIN- is connected to the signal input of inverter 109 which includes PFET 117 and NFET 115. The signal output of inverter 109 is connected to pre-amplifier output VI-. The outputs VI+ and VI- are each connected to a terminal of switch 119 that is controlled by signal PHR that is closed during the reset phase to equalize the voltages of VI+ and VI-. Signal PHR is provided by a controller 106.

Pre-amplifier 103 includes two self-biased inverters 125 and 127. Inverter 125 includes PFET 131 and NFET 129. The signal input and signal output of inverter 125 are connected to pre-amplifier output VI-. Inverter 127 includes PFET 135 and NFET 133. The signal input and signal output of inverter 127 are connected to pre-amplifier output VI+.

Pre-amplifier 103 includes a latch of two cross coupled inverters 137 and 139. Inverter 137 includes PFET 143 and NFET 141. The signal input of inverter 137 is connected to VI+ and connected to the signal output of inverter 139. Inverter 139 includes PFET 147 and NFET 145. The signal input of inverter 139 is connected to VI- and connected to the signal output of inverter 137.

The high supply input of inverters 107, 109, 125, 127, 137, and 139 (the sources of the PFETs of the inverters) are coupled to the high supply voltage terminal VDD through switch 123 that is controlled by the PHPA signal from controller 106. The low supply input of inverters 107, 109, 125, 127, 137, and 139 (the sources of the NFETs of the inverters) are coupled to the low supply voltage terminal VSS through switch 121 that is controlled by the PHPA signal. In one embodiment, switch 123 is implemented with a PFET and switch 121 is implemented with an NFET, but these switches can be implemented with other types of switches (e.g., passgates, transmission gates, other types of transistors) in other embodiments.

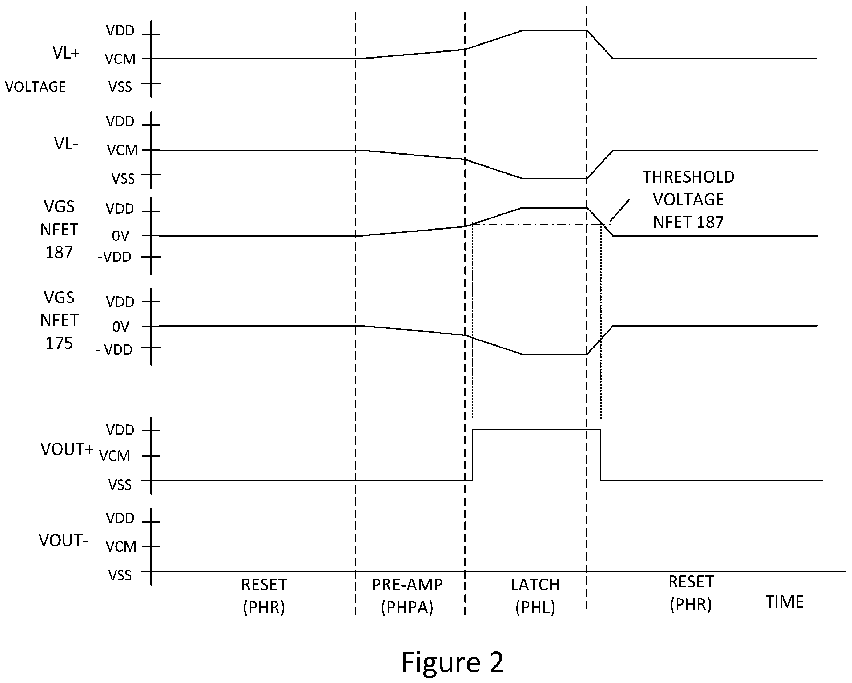

Switches 123 and 121 are closed during the pre-amplification phase to provide power to the circuitry of pre-amplifier 103 to bias the high supply nodes (e.g., the high supply inputs of inverters 107, 109, 125, 127, 137, and 139) and the low supply nodes (e.g., the low supply inputs of inverters 107, 109, 125, 127, 137, and 139) at VDD and VSS, respectively. During other phases of comparison circuit 101 (e.g., reset phase, latch phase) switches 123 and 121 are open. See the discussion of Figure 2 below.

Comparison circuit 101 includes a latch 104 that includes cross coupled inverters 155 and 157. In one embodiment, inverters 155 and 157 each include a PFET and an NFET (not shown but similar to the latch circuit of inverters 137 and 139). The signal input of inverter 155 is connected to a terminal of switch 153, to the output of inverter 157, and to the input VL- of latch 105. The input of inverter 157 is connected to a terminal of switch 151, to the output of inverter 155, and to input VL+ of latch 105. The other terminal of switch 153 is connected to output VI+ of pre-amplifier 103, and the other terminal of switch 151 is connected to output VI- of pre-amplifier 103. In one embodiment, switch 153 and switch 151 are implemented with NFETs, but may be implemented with other types of switches (passgates, transmission gates, or other types of transistors such as e.g., PFETs).

The high supply input of inverter 155 is coupled to the high supply voltage terminal VDD through switch 165, and the low supply terminal of inverter 155 is coupled to the low supply voltage terminal VSS through switch 163. The high supply input of inverter 157 is coupled to the high supply voltage terminal VDD through switch 161, and the low supply terminal of inverter 157 is coupled to the low supply voltage terminal VSS through switch 159. Switches 165, 163, 161, and 159 are controlled by signal PHL from controller 106 and are conductive during a latching phase and nonconductive during a pre-amplification phase and the reset phase. In one embodiment switches 165 and 161 are implemented with PFETs and switches 163 and 159 are implemented with NFETs, but they can be implemented with other types of switches (passgates or other types of transistors) in other embodiments. In some embodiments, both high supply inputs of inverters 155 and 157 can be coupled to VDD through a single switch and both low supply inputs of inverters 155 and 157 can be coupled to VSS through a single switch.

Comparison circuit 101 includes a latch 105. Latch 105 includes inputs VL+ and VL- that are connected to the outputs of inverter 155 and inverter 157, respectively. Latch 105 includes switch 167 that is connected at one terminal to input VL+ and at another terminal to input VL-. Switch 167 is controlled by the PHR signal from controller 106 and is conductive (closed) during the reset phase to equalize the voltages of input VL+ and input VL- during the reset phase. Switch 167 is open (nonconductive) during the pre-amplification phase and the latching phase.

Latch 105 includes two sets of inverters with each set coupled in a signal series path between a latch input and latch output. One set includes inverters 183 and 185 where the signal input of first in series inverter 183 is connected to latch input VL+ and the signal output of last in series inverter 185 is connected to latch output VOUT+. The signal output of inverter 183 is connected to the signal input of inverter 185. Inverter 183 includes a PFET 189 whose source (the high supply input of inverter 183) is connected to high supply voltage terminal VDD and whose drain is connected to the drain of NFET 187 and the signal output of inverter 183. Inverter 183 includes NFET 187 whose gate is connected to the gate of PFET 189 and to latch input VL+ at the signal input of inverter 183. The source of NFET 187 (the low supply input of inverter 183) is connected to latch input VL- such that the low supply input of inverter 183 is biased by latch input VL-.

Inverter 185 includes PFET 193 and NFET 191. The gates of PFET 193 and NFET 191 are connected at the signal input of inverter 185 to the signal output of inverter 183. The high supply input of inverter 185 (the source of PFET 193) is connected to high supply voltage terminal VDD and the low supply input of inverter 185 (the source of NFET 191) is connected to the low supply voltage terminal VSS. The drains of PFET 193 and NFET 191 are connected at the signal output of inverter 185 to latch output VOUT+.

The signal output of inverter 171 is connected to the signal input of inverter 173. Inverter 171 includes a PFET 177 whose source (the high supply input of inverter 171) is connected to high supply voltage terminal VDD and whose drain is connected to the drain of NFET 175 and to the signal output of inverter 171. Inverter 171 includes NFET 175 whose gate is connected to the gate of PFET 177 and to latch input VL- at the signal input of inverter 171. The source of NFET 175 (the low supply input of inverter 171) is connected to latch input VL+ such that the low supply input of inverter 171 is biased by latch input VL+.

Inverter 173 includes PFET 181 and NFET 179. The gates of PFET 181 and NFET 179 are connected at the signal input of inverter 173 to the signal output of inverter 171. The high supply input of inverter 173 (the source of PFET 181) is connected to high supply voltage terminal VDD and the low supply input of inverter 173 (the source of NFET 179) is connected to the low supply voltage terminal VSS. The drains of PFET 181 and NFET 179 are connected at the signal output of inverter 173 to latch output VOUT-.

In one embodiment, the VDD high supply voltage terminal is biased at .8V and the VSS low supply voltage terminal is biased at a ground voltage. However, these supply voltage terminals may be biased at other supply voltages including negative voltages for VSS.

In other embodiments, a comparison circuit may have other configurations, include other circuitry and/or operate in other modes. For example, some embodiments (e.g., embodiments with high input voltages) do not include latch 104. Although the inverters of Figure 1 are shown being implemented with a P-type transistor (e.g., a PFET) in series with an N-type transistor (e.g., and NFET), at least some of the inverters of Figure 1 may be implemented with other inverter configurations in other embodiments. Also, pre-amplifier 103 may have other configurations in other embodiments. Circuit 101 may be implemented with other types of transistors in other embodiments (e.g., bipolar).

Figure 2 is a timing diagram showing voltages of comparison circuit 101 during operation according to one embodiment of the present invention. In the embodiment shown, comparison circuit 101 operates in three phases: a reset phase (PHR), a pre-amplification ("pre-amp") phase (PHPA), and a latch phase (PHL). These sequential phases are repeatedly performed to provide a differential indication at VOUT+ and VOUT- of a comparison of the voltage of VIN+ with the voltage of VIN+. Controller 106 controls the timing of the phases.

During the reset phase, the PHR signal is asserted to close switch 119 to equalize the voltages of VI+ and VI- at the common mode voltage of VI+ and VI- during the previous latch phase. The PHR signal being asserted also closes switch 167 to equalize the voltages of VL+ and VL- at the common mode voltage (VCM) of VL+ and VL- during the previous latch phase. Because VL+ and VL- are equalized during the reset phase, the gate-to-source voltages (VGS) of NFETs 187 and 175 are at 0V.

During the reset phase, the PHPA signal is non asserted such that switches 151 and 153 are open to isolate VI+ and VI- from latch 104. The PHPA signal being in a nonconductive state during the reset phase also opens switches 123 and 121 so that the inverters of pre-amplifier 103 are not biased at their supply voltage inputs by high supply voltage terminal VDD and low supply voltage terminal VSS. Thus, none of the transistors of the inverters of pre-amplifier 103 can pull the voltages of either output VI+ or VI- away form the common mode voltage.

During the reset phase, the PHL signal is non asserted such that switches 159, 161, 163, and 165 are nonconductive so that inverters 157 and 155 are not biased by supply voltages VDD and VSS. Thus, inverters 157 and 155 cannot pull the voltages of latch inputs VL+ and VL- from the common mode voltage.

During the reset phase, the voltages of latch outputs VOUT+ and VOUT- are pulled to the low voltage state of VSS. In some embodiments. The threshold voltages of PFETs 189 and 177 are less than the voltage difference between VDD and the common mode voltages of VL+ and VL- such that PFETs 189 and 177 will be conductive during the reset phase. With PFETs 189 and 177 being conductive, NFETs 191 and 179 are conductive to pull the voltages of VOUT+ and VOUT-, respectively, to VSS. In one embodiment where VDD is .8V, VSS is ground, and the common mode voltage is .4V, PFETs 189 and 177 have a threshold voltage of .3V such that they are both conductive in the reset phase. In some embodiments, NFETs 175 and 187 also have a threshold voltage of .3V, but these threshold voltages may be of other values in other embodiments.

During the pre-amplification phase (PHPA), switches 121 and 123 are closed to bias the low supply voltage nodes of pre-amplifier 103 at VSS and bias the high supply voltage nodes of pre-amplifier 103 at VDD. Switch 119 is open so that Vi+ and VI- are no longer equalized. Switches 151 and 153 are closed and switch 167 is open. As result of these switch positions, a voltage difference at VIN+ and VIN- begins to create a voltage difference between VI+ and VI- and between VL+ and VL- to pull those voltages in opposite directions. In the embodiment of Figure 2, VIN+ is at a higher voltage than VIN- which causes VL+ to increase and VL- to decrease during the pre-amplification phase.

During the pre-amplification phase, inverters 125 and 127 act to pull VIand VI+ to the threshold voltage of inverters 125 and 127, respectfully, which is designed to be approximately the common mode voltage of VIN+ and VIN-. Self-biased inverters 125 and 127 act to reduce the common mode sensitivity of pre-amplifier 103, but they also reduce the gain of the pre-amplifier 103.

Cross coupled inverters 137 and 139 act to enhance the rate of increase of the voltage difference between VI- and VI+ (and between VL+ and VL-) (i.e., increase the gain of pre-amplifier 103) for the given amount of transistor current. The transistors of inverters 137 and 139 are stronger than the transistors of inverters 125 and 127 so as to overcome the effect of self-biased inverters 125 and 127. In some embodiments, the size of the transistors of inverters 125, 127, 137 and 139 can be adjusted to tailor the gain versus the common mode sensitivity of pre-amplifier 103. In addition, because pre-amplifier 103 includes only one set of internal signal nodes (VI-, VI+), the speed of pre-amplifier 103 is greater than with a pre-amplifier with multiple sets of nodes.

During the latch phase, switches 151 and 153 are open to isolate VI+ and VI- from VL- and VL+, respectively. Also, switches 123 and 121 are open so that the supply nodes of the inverters of pre-amplifier 103 are unbiased.

During the latch phase, switches 159, 161, 163, and 165 are closed so that the high supply inputs of inverters 155 and 157 are biased at VDD and the low supply inputs of inverters 155 and 157 are biased at VSS. Because the cross coupled inverters 155 and 157 are powered during the latch phase, the voltage difference between VL+ and VL- increases at a higher rate. As shown in Figure 2, the voltage of VL+ rises at a faster rate and the voltage of VL- falls at a faster rate during the latch phase.

Because the signal inputs of inverters 183 and 171 are connected to one latch input (VL+, VL-), and the low supply inputs of inverters 183 and 171 are connected to the other latch input (VL-,VL+), the latch outputs (VOUT+. VOUT-) will change state when the voltage difference between the latch inputs exceeds the threshold voltage of one of NFETs 187 and 175, depending upon which latch input has the higher voltage.

Figure 2 shows a gate-to-source voltage of NFET 187 (VGS NFET 187), which is the voltage of VL+ minus the voltage of VL-. Figure 2 also shows a gate-to-source voltage of NFET 175 (VGS NFET 175), which is the voltage of VL- minus the voltage of VL+. As shown in Figure 2, the VGS voltages of NFETs 187 and 175 are at 0V during the reset phase in that VL+ and VL- are equalized at the same voltage.

During the pre-amplification phase, the gate-to-source voltages (VGS) of NFETs 187 and 175 begin to diverge in opposite directions as pre-amplifier 103 amplifies the difference between VI- and VI+. During the latch phase, the VGS voltages diverge at an even fast rate due to the powering of cross coupled inverter 155 and 157. When NFET 187 or NFET 175 has a positive VGS that surpasses its threshold, that NFET becomes conductive to make the PFET (193 or 181) of the subsequent inverter (185 or 173) conductive to pull VOUT+ or VOUT- to a high voltage state. The NFET (189 or 177) with a negative VGS remains nonconductive where its corresponding latch output (VOUT+, VOUT-) does not change.

In the embodiment of Figure 2, because VL+ was rising and VL- was falling, NFET 187 becomes conductive when its gate-to-source volage (VGS) rises above its threshold voltage (e.g..3V in some embodiments). This happens when VL+ minus VL- is greater than the threshold voltage of NFET 187. NFET 187 becoming conductive pulls makes PFET 193 to pull its corresponding latch output VOUT+ to a high voltage state of VDD, whereas VOUT- is remains as its low voltage state of VSS.

After VOUT+ changes states to VDD in Figure 2, VL+ continues to rise and VL- continues to fall until VL+ reaches VDD and VL- reaches VSS. Because VGS NFET 187 represents the voltage of VL+ minus the voltage of VL-, it rises to VDD at twice the rate as VL+ rises to VDD. Because VGS NFET 175 represents the voltage of VL- minus the voltage of VL+, it falls to -VDD at twice the rate as VL- falls to VSS.

Because the sources of NFETs 187 and 175 are biased by the other latch input that is not applied to its signal input, their gate-to-source voltages will change at twice the rate as the latch input voltages applied to their signal inputs due to the diverging directions of the voltages of the latch inputs (VL+, VL-). Accordingly, the NFETs will turn on faster than if the sources of each NFET were biased at VSS, thereby providing for a faster latch and a faster comparison circuit.

Upon the commencement of the second reset phase, switches 159, 161, 163, and 165 open so that inverters 157 and 155 are unbiased. Switch 119 is at a closed state to equalize the voltages on VI+ and VI- to their common mode voltage. Switch 167 is closed to equalize the voltages of VL+ and VL- to their common mode voltage (VCM). Due to the equalization of the voltages of VL+ and VL-, the gate-to-source voltage of NFETs 187 and 175 return to 0 volts. As shown in Figure 2, when the gate-to-source voltage of NFET 187 falls past its threshold voltage, VOUT+ returns to its low voltage state.

Accordingly, comparison circuit 101 includes two outputs (VOUT+ and VOUT-) that during a reset phase at are at the same low voltage state and during a latch phase are at complementary voltage states depending upon whether VIN+ or VIN- is at a higher voltage with respect to each other. With such an embodiment, only one latch output is required to change state to indicate a volage comparison result during the latch phase. In other embodiments, comparison circuit may have a different number of phases.

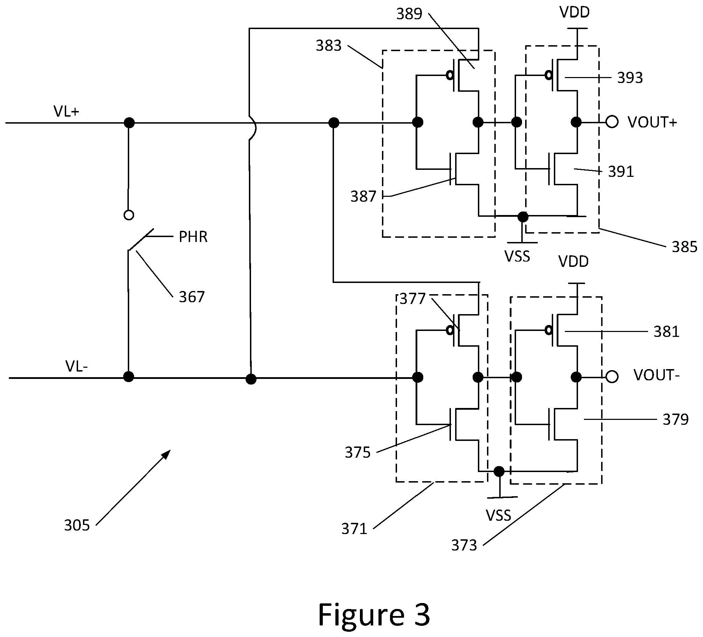

Figure 3 is a circuit diagram of another latch 305 according to an embodiment of the present invention. Latch 305 is similar to latch 105 of Figure 1 except that the high supply inputs (the sources of PFETs 389 and 377) of the first in series inverters (383 and 371) are connected to the opposing latch input (VL- and VL+, respectively) and the low supply inputs (the sources of NFETs 387 and 375) of the first in series inverters (383 and 371) are connected to VSS.

The signal input of inverter 383 is connected to latch input VL+ and the signal input of inverter 371 is connected to latch input VL-. Latch 305 includes a switch 367 for equalizing the latch inputs VL+ and VL- during a reset phase. The signal output of inverter 383 is connected to the signal input of inverter 385, which includes PFET 393 and NFET 391. The signal output of inverter 371 is connected to the signal input of inverter 373, which includes PFET 381 and 379.

NFETs 387 and 375 have a threshold voltage that is less than the common mode voltage of VL+ and VL-. Thus, when VL+ and VL- are at the common mode voltage, NFETs 387 and 375 are conductive so that VOUT+ and VOUT- are both at a high voltage state. As the voltages of VL+ and VL- diverge in the latch phase, either PFET 389 or PFET 377 will become conductive when its gate-to-source voltage falls below its threshold voltage (or its source-to-gate threshold rises above its threshold voltage). Upon this condition, the latch output (VOUT+, VOUT-) corresponding to the conductive PFET is pulled to its low voltage state (VSS), where VOUT+ and VOUT- are in complementary states to indicate which input has the higher voltage. In some embodiments, each set of inverters can have more than two inverters in the signal path such that the reset voltage state of VOUT+ and VOUT- can be at VSS.

Comparison circuit 101 can be used to provide a comparison of two input voltages in a variety of systems such as e.g., memories, serial interfaces, data converters, computational hardware, and ADCs. In some embodiments, comparison circuit 101 may be used in a successive approximation register (SAR) analog to digital converter (ADC) where the relatively high speed of comparison circuit 101 and large differential gain may be beneficial for achieving high clock speeds and high resolution. Accordingly, such a comparison circuit may be beneficial for high frequency applications (e.g., 5 GHz or greater) such as with 5G/6G implementations and other wireless systems or with auto radar systems, and in serializer and deserializer (SerDes) applications.

In some embodiments having large input voltages, the gain of pre-amplifier 103 may be large enough that latch 104 is not needed. Furthermore, for lower frequencies, the input inverters 107 and 109 can be relatively small in size, thereby providing for a small input capacitance and lower noise. In some embodiments, the comparison circuit can be optimized for a wide range of frequencies without modifying the design by adjusting the length of the pre-amplification phase.

In some embodiments, each set of one or more inverters may have only one inverter in the signal path or may have more than two inverters in the signal path. One advantage of a set having two or more inverters in a signal path is that the latch outputs (VOUT+ and VOUT-) may transition faster to well-defined complementary digital output states based a relatively small differential latch input voltages around a common mode.

Features described herein with respect to one embodiment may be implemented in other embodiments described herein. A source or a drain is a current terminal for a FET (field effect transistor). A gate is a control terminal for a FET. Two devices can be "coupled" to each other either through other devices or by being connected to each other. For example, referring to Figure 1, Latch inputs VL+ and VL- are coupled through switch 167. Latch input VL+ is also coupled to the gate to PFET 189 by being connected to the gate of PFET 189.

In one embodiment, a circuit includes a latch. The latch includes a first input, a second input, a first output, a second output, and a first set of one or more inverters coupled in a signal series path. A signal input of a first in series invertor of the first set is connected to the first input and a signal output of a last in series inverter of the first set is connected to the first output. The first in series inverter of the first set includes a first supply input that is configured to be biased by the second input. The latch includes a second set of one or more inverters coupled in a signal series path. A signal input of a first in series inverter of the second set is connected to the second input and a signal output of a last in series inverter of the second set is connected to the second output. The first in series inverter of the second set includes a first supply input that is configured to be biased by the first input. During a reset phase, the first output and the second output are configured to be set to a same output value state. During a latching phase, the first output and the second output are configured to be latched at complementary output value states dependent upon voltages of the first input and the second input.

## Claims

1. A circuit (101) comprising:
a latch (104), the latch comprising:
a first input (VL+);
a second input (VL-);
a first output (VOUT+);
a second output (VOUT-);
a first set of one or more inverters (183, 185) coupled in a signal series path, wherein
a signal input of a first in series inverter (183) of the first set is connected to the first input and a signal output of a last in series inverter (185) of the first set is connected to the first output, wherein the first in series inverter of the first set includes a first supply input that is configured to be biased by the second input;
a second set of one or more inverters (171, 173) coupled in a signal series path,
wherein a signal input of a first in series inverter (171) of the second set is connected to the second input and a signal output of a last in series inverter (173) of the second set is connected to the second output, wherein the first in series inverter of the second set includes a first supply input that is configured to be biased by the first input;
wherein during a reset phase (PHR),
the first output and the second output are configured to be set to a same output value state, wherein during a latching phase (PHL),
the first output and the second output are configured to be latched at complementary output value states dependent upon voltages of the first input and the second input.

2. The circuit of claim 1 wherein during the reset phase, the first input and the second input are configured to be equalized in voltage.

3. The circuit of claim 2 wherein during the reset phase, the first input and the second input are configured to be equalized to a common mode voltage of voltages of the first input and the second input prior to equalization.

4. The circuit of any preceding claim wherein the first set of one or more inverters includes two or more inverters and the second set of one or more inverters includes two or more inverters.

5. The circuit of any preceding claim wherein:
the first in series inverter of the first set and the first in series inverter of the second set each includes a P-type transistor in coupled in series with an N-type transistor;
for the first in series inverter of the first set, a first current terminal of one of the P-type transistor or the N-type transistor is configured to be biased by the second input, a first current terminal of the other of the P-type transistor or the N-type transistor is configured to be biased by a voltage supply terminal;
for the first in series inverter of the second set, a first current terminal of one of the P-type transistor or the N-type transistor is configured to be biased by the first input, a first current terminal of the other of the P-type transistor or the N-type transistor is configured to be biased by the voltage supply terminal.

6. The circuit of claim 5 wherein:
during a reset phase, the first input and the second input are configured to be equalized in voltage;
for the first in series inverter of the first set, the other of the P-type transistor or the N-type transistor is conductive when the first input and the second input are equalized in voltage;
for the first in series inverter of the second set, the other of the P-type transistor or the N-type transistor is conductive when the first input and the second input are equalized in voltage.

7. The circuit of claim 5 or 6 wherein;
for the first in series inverter of the first set and the first in series inverter of the second set, the P-type transistor is a PFET and the N-type transistor is an NFET;
for the first in series inverter of the first set, a source terminal of the NFET is connected to the second input, and a source terminal of the PFET is configured to be biased by a high voltage supply terminal;
for the first in series inverter of the second set, a source terminal of the NFET is connected to the first input, and a source terminal of the PFET is configured to be biased by the high voltage supply terminal.

8. The circuit of claim 5 or 6 wherein:
for the first in series inverter of the first set and the first in series inverter of the second set, the P-type transistor is a PFET and the N-type transistor is an NFET;
for the first in series inverter of the first set, a source terminal of the PFET is connected to the second input, and a source terminal of the NFET is configured to be biased by a low voltage supply terminal;
for the first in series inverter of the second set, a source terminal of the PFET is connected to the first input, and a source terminal of the NFET is configured to be biased by the low voltage supply terminal.

9. The circuit of any preceding claim further comprising:
a comparison circuit (101), the comparison circuit including the latch and a pre-amplifier circuit (103), the pre-amplifier circuit including:
a first input (VIN+);
a second input (VIN -);
a first output (VI+) coupled to the first input of the latch;
a second output (VI-) coupled to the second input of the latch;
wherein the first output of the latch and the second output of the latch are latched at complementary output value states indicative of a comparison of voltages of the first input of the pre-amplifier and the second input of the pre-amplifier.

10. The circuit of claim 9 wherein the pre amplifier comprises:
a first self-biased inverter (125) including a signal input and a signal output connected to first output of the pre-amplifier:
a second self-biased inverter (127) including a signal input and a signal output connect to the second output of the pre-amplifier;
wherein during a pre-amplification phase (PHPA) of the comparison circuit, a high side supply input of the first self-biased inverter is configured to be biased by a high supply voltage terminal (VDD) and a low side supply input of the first self-biased inverter is configured to be biased by a low supply voltage terminal (VSS);
wherein during the pre-amplification phase, a high side supply input of the second self-biased inverter is configured to be biased by the high supply voltage terminal and a low side supply input of the second self-biased inverter is configured to be biased by the low supply voltage terminal;
wherein during a reset phase of the comparison circuit, the high side supply inputs of the first self-biased inverter and the second self-biased inverter are not configured to be biased by the high supply voltage terminal and low supply inputs of the first self-biased inverter and the second self-biased inverter are not configured to be biased by the low supply voltage terminal.

11. The circuit of claim 9, wherein:
the first output of the pre-amplifier is coupled to the first input of the latch via a first switch (153) and the second output of the pre-amplifier is coupled to the second input of the latch via a second switch (151);
wherein during the reset phase, the first switch and the second switch are configured to be open, during a pre-amplification phase, the first switch and the second switch are configured to be closed;
wherein during the reset phase, the first output of the pre-amplifier and the second output of the pre-amplifier are configured to be equalized, during the pre-amplification phase, the first output of the pre-amplifier and the second output of the pre-amplifier are not equalized.

12. The circuit of claim 11 wherein during the pre-amplification phase, the pre-amplifier is configured to be biased by a high supply voltage terminal and be biased by a low supply voltage terminal for providing power to circuitry of the pre-amplifier, wherein during the reset mode, the pre-amplifier is configured to not be biased by the high supply voltage terminal and the low supply voltage terminal.

13. The circuit of any of claims 9 to 12, wherein the comparison circuit further comprises a second latch (104) including:
a first latch inverter (155) and a second latch inverter (157) configured in a cross coupled configuration;
wherein a signal input of the first latch inverter is coupled to the second output of the pre-amplifier, to a signal output of the second latch inverter, and to the second input of the latch;
wherein a signal input of the second latch inverter is coupled to the first output of the pre-amplifier, to the signal output of the first latch inverter, and to the first input of the latch.

14. The circuit of claim 13, wherein:
the signal input of the first latch inverter is coupled to the second output of the pre-amplifier through a first switch;
the signal input of the second latch inverter is coupled to the first output of the pre-amplifier through a second switch;
wherein during the reset phase, the first switch and the second switch are open;
wherein during a pre-amplification phase, the first switch and the second switch are closed.

15. The circuit of claim 14 wherein:
during a latching phase, a high side supply input of the first latch inverter is configured to be biased by a high supply voltage terminal and a low side supply input of the first latch inverter is configured to be biased by a low supply voltage terminal to supply power to the first latch inverter;
during the latching phase, a high side supply input of the second latch inverter is configured to be biased by the high supply voltage terminal and the low side supply input of the second latch inverter is configured to be biased by the low supply voltage terminal to supply power to the second latch inverter;
wherein during the reset phase and the pre-amplification phase, the high side supply input of the first latch inverter and the low side supply input of the first latch inverter are configured to be unbiased;
wherein during the reset phase and the pre-amplification phase, the high side supply input of the second latch inverter and the low side supply input of the second latch inverter is configured to be unbiased.

## Patentansprüche

1. Schaltung (101), die Folgendes umfasst:
einen Latch (104), wobei der Latch Folgendes umfasst:
einen ersten Eingang (VL+);
einen zweiten Eingang (VL-);
einen ersten Ausgang (VOUT+);
einen zweiten Ausgang (VOUT-);
einen ersten Satz von einem oder mehreren Invertern (183, 185), die in einem Signalserienpfad gekoppelt sind, wobei ein Signaleingang eines ersten in Reihe geschalteten Inverters (183) des ersten Satzes mit dem ersten Eingang verbunden ist und ein Signalausgang eines letzten in Reihe geschalteten Inverters (185) des ersten Satzes mit dem ersten Ausgang verbunden ist, wobei der erste in Reihe geschaltete Inverter des ersten Satzes einen ersten Versorgungseingang aufweist, der dazu ausgelegt ist, durch den zweiten Eingang vorgespannt zu werden;
einen zweiten Satz von einem oder mehreren Invertern (171, 173), die in einem Signalserienpfad gekoppelt sind, wobei ein Signaleingang eines ersten in Reihe geschalteten Inverters (171) des zweiten Satzes mit dem zweiten Eingang verbunden ist und ein Signalausgang eines letzten in Reihe geschalteten Inverters (173) des zweiten Satzes mit dem zweiten Ausgang verbunden ist, wobei der erste in Reihe geschaltete Inverter des zweiten Satzes einen ersten Versorgungseingang beinhaltet, der dazu ausgelegt ist, durch den ersten Eingang vorgespannt zu werden;
wobei während einer Rücksetzphase (PHR) der erste Ausgang und der zweite Ausgang dazu ausgelegt sind, auf einen gleichen Ausgangswertzustand gesetzt zu werden, wobei während einer Latch-Phase (PHL) der erste Ausgang und der zweite Ausgang dazu ausgelegt sind, bei komplementären Ausgangswertzuständen in Abhängigkeit von Spannungen des ersten Eingangs und des zweiten Eingangs gelatcht zu werden.

2. Schaltung nach Anspruch 1, wobei während der Rücksetzphase der erste Eingang und der zweite Eingang dazu ausgelegt sind, in der Spannung entzerrt zu werden.

3. Schaltung nach Anspruch 2, wobei während der Rücksetzphase der erste Eingang und der zweite Eingang dazu ausgelegt sind, vor dem Entzerren auf eine Gleichtaktspannung von Spannungen des ersten Eingangs und des zweiten Eingangs entzerrt zu werden.

4. Schaltung nach einem der vorhergehenden Ansprüche, wobei der erste Satz von einem oder mehreren Invertern zwei oder mehr Inverter beinhaltet und der zweite Satz von einem oder mehreren Invertern zwei oder mehr Inverter beinhaltet.

5. Schaltung nach einem der vorhergehenden Ansprüche, wobei:
der erste in Reihe geschaltete Inverter des ersten Satzes und der erste in Reihe geschaltete Inverter des zweiten Satzes jeweils einen p-Typ-Transistor beinhalten, der in Reihe mit einem n-Typ-Transistor gekoppelt ist;
für den ersten in Reihe geschalteten Inverter des ersten Satzes ein erster Stromanschluss des P-Typ-Transistors oder des N-Typ-Transistors dazu ausgelegt ist, durch den zweiten Eingang vorgespannt zu werden, ein erster Stromanschluss des anderen des P-Typ-Transistors oder des N-Typ-Transistors dazu ausgelegt ist, durch einen Spannungsversorgungsanschluss vorgespannt zu werden;
für den ersten in Reihe geschalteten Inverter des zweiten Satzes ein erster Stromanschluss des P-Typ-Transistors oder des N-Typ-Transistors dazu ausgelegt ist, durch den ersten Eingang vorgespannt zu werden, ein erster Stromanschluss des anderen des P-Typ-Transistors oder des N-Typ-Transistors dazu ausgelegt ist, durch den Spannungsversorgungsanschluss vorgespannt zu werden.

6. Schaltung nach Anspruch 5, wobei:
während einer Rücksetzphase der erste Eingang und der zweite Eingang dazu ausgelegt sind, in der Spannung entzerrt zu werden;
für den ersten in Reihe geschalteten Inverter des ersten Satzes der andere des P-Typ-Transistors oder des N-Typ-Transistors leitend ist, wenn der erste Eingang und der zweite Eingang in Spannung entzerrt sind;
für den ersten in Reihe geschalteten Inverter des zweiten Satzes der andere des P-Typ-Transistors oder des N-Typ-Transistors leitend ist, wenn der erste Eingang und der zweite Eingang in Spannung entzerrt sind.

7. Schaltung nach Anspruch 5 oder 6, wobei:
für den ersten in Reihe geschalteten Inverter des ersten Satzes und den ersten in Reihe geschalteten Inverter des zweiten Satzes der P-Typ-Transistor ein PFET und der N-Typ-Transistor ein NFET ist;
für den ersten in Reihe geschalteten Inverter des ersten Satzes ein Source-Anschluss des NFET mit dem zweiten Eingang verbunden ist, und ein Source-Anschluss des PFET dazu ausgelegt ist, durch einen Hochspannungsversorgungsanschluss vorgespannt zu werden;
für den ersten in Reihe geschalteten Inverter des zweiten Satzes ein Source-Anschluss des NFET mit dem ersten Eingang verbunden ist, und ein Source-Anschluss des PFET dazu ausgelegt ist, durch den Hochspannungsversorgungsanschluss vorgespannt zu werden.

8. Schaltung nach Anspruch 5 oder 6, wobei:
für den ersten in Reihe geschalteten Inverter des ersten Satzes und den ersten in Reihe geschalteten Inverter des zweiten Satzes der P-Typ-Transistor ein PFET und der N-Typ-Transistor ein NFET ist;
für den ersten in Reihe geschalteten Inverter des ersten Satzes ein Source-Anschluss des PFET mit dem zweiten Eingang verbunden ist, und ein Source-Anschluss des NFET dazu ausgelegt ist, durch einen Niederspannungsversorgungsanschluss vorgespannt zu werden;
für den ersten in Reihe geschalteten Inverter des zweiten Satzes ein Source-Anschluss des PFET mit dem ersten Eingang verbunden ist, und ein Source-Anschluss des NFET dazu ausgelegt ist, durch den Niederspannungsversorgungsanschluss vorgespannt zu werden.

9. Schaltung nach einem vorhergehenden Anspruch, die ferner Folgendes umfasst:
eine Vergleichsschaltung (101), wobei die Vergleichsschaltung den Latch und eine Vorverstärkerschaltung (103) aufweist, wobei die Vorverstärkerschaltung Folgendes aufweist:
einen ersten Eingang (VIN+);
einen zweiten Eingang (VIN-);
einen ersten Ausgang (VI+), der mit dem ersten Eingang des Latches gekoppelt ist;
einen zweiten Ausgang (VI-), der mit dem zweiten Eingang des Latches gekoppelt ist;
wobei der erste Ausgang des Latches und der zweite Ausgang des Latches bei komplementären Ausgangswertzuständen zwischengespeichert sind, die einen Vergleich von Spannungen des ersten Eingangs des Vorverstärkers und des zweiten Eingangs des Vorverstärkers angeben.

10. Schaltung nach Anspruch 9, wobei der Vorverstärker Folgendes umfasst:
einen ersten selbstvorgespannten Inverter (125), der einen Signaleingang und einen Signalausgang aufweist, die mit dem ersten Ausgang des Vorverstärkers verbunden sind:
einen zweiten selbstvorgespannten Inverter (127), der einen Signaleingang und einen Signalausgang aufweist, die mit dem zweiten Ausgang des Vorverstärkers verbunden sind;
wobei während einer Vorverstärkungsphase (PHPA) der Vergleichsschaltung ein High-Side-Versorgungseingang des ersten selbstvorgespannten Inverters dazu ausgelegt ist, durch einen Hochversorgungsspannungsanschluss (VDD) vorgespannt zu werden, und ein Low-Side-Versorgungseingang des ersten selbstvorgespannten Inverters dazu ausgelegt ist, durch einen Niederversorgungsspannungsanschluss (VSS) vorgespannt zu werden;
wobei während der Vorverstärkungsphase ein High-Side-Versorgungseingang des zweiten selbstvorgespannten Inverters dazu ausgelegt ist, durch den Hochversorgungsspannungsanschluss vorgespannt zu werden, und ein Low-Side-Versorgungseingang des zweiten selbstvorgespannten Inverters dazu ausgelegt ist, durch den Niederversorgungsspannungsanschluss vorgespannt zu werden;
wobei während einer Rücksetzphase der Vergleichsschaltung die High-Side-Versorgungseingänge des ersten selbstvorgespannten Inverters und des zweiten selbstvorgespannten Inverters nicht dazu ausgelegt sind, durch den Hochversorgungsspannungsanschluss vorgespannt zu werden, und niedrige Versorgungseingänge des ersten selbstvorgespannten Inverters und des zweiten selbstvorgespannten Inverters nicht dazu ausgelegt sind, durch den Niederversorgungsspannungsanschluss vorgespannt zu werden.

11. Schaltung nach Anspruch 9, wobei:
der erste Ausgang des Vorverstärkers über einen ersten Schalter (153) mit dem ersten Eingang des Latches gekoppelt ist und der zweite Ausgang des Vorverstärkers über einen zweiten Schalter (151) mit dem zweiten Eingang des Latches gekoppelt ist;
wobei während der Rücksetzphase der erste Schalter und der zweite Schalter dazu ausgelegt sind, während einer Vorverstärkungsphase geöffnet zu sein, der erste Schalter und der zweite Schalter dazu ausgelegt sind, geschlossen zu sein;
wobei während der Rücksetzphase der erste Ausgang des Vorverstärkers und der zweite Ausgang des Vorverstärkers dazu ausgelegt sind, während der Vorverstärkungsphase entzerrt zu werden, der erste Ausgang des Vorverstärkers und der zweite Ausgang des Vorverstärkers nicht entzerrt werden.

12. Schaltung nach Anspruch 11, wobei während der Vorverstärkungsphase der Vorverstärker dazu ausgelegt ist, durch einen Hochversorgungsspannungsanschluss vorgespannt zu werden und durch einen Niederversorgungsspannungsanschluss vorgespannt zu werden, um eine Schaltungsanordnung des Vorverstärkers mit Leistung zu versorgen, wobei während des Rücksetzmodus der Vorverstärker dazu ausgelegt ist, nicht durch den Hochversorgungsspannungsanschluss und den Niederversorgungsspannungsanschluss vorgespannt zu werden.

13. Schaltung nach einem der Ansprüche 9 bis 12, wobei die Vergleichsschaltung ferner einen zweiten Latch (104) umfasst, der Folgendes aufweist:
einen ersten Latch-Inverter (155) und einen zweiten Latch-Inverter (157), die in einer kreuzgekoppelten Konfiguration ausgelegt sind;
wobei ein Signaleingang des ersten Latch-Inverters mit dem zweiten Ausgang des Vorverstärkers, mit einem Signalausgang des zweiten Latch-Inverters und mit dem zweiten Eingang des Latch gekoppelt ist;
wobei ein Signaleingang des zweiten Latch-Inverters mit dem ersten Ausgang des Vorverstärkers, mit dem Signalausgang des ersten Latch-Inverters und mit dem ersten Eingang des Latches gekoppelt ist.

14. Schaltung nach Anspruch 13, wobei:
der Signaleingang des ersten Latch-Inverters über einen ersten Schalter mit dem zweiten Ausgang des Vorverstärkers gekoppelt ist;
der Signaleingang des zweiten Latch-Inverters über einen zweiten Schalter mit dem ersten Ausgang des Vorverstärkers gekoppelt ist;
wobei während der Rücksetzphase der erste Schalter und der zweite Schalter offen sind;
wobei während einer Vorverstärkungsphase der erste Schalter und der zweite Schalter geschlossen sind.

15. Schaltung nach Anspruch 14, wobei:
während einer Latch-Phase ein High-Side-Versorgungseingang des ersten Latch-Inverters dazu ausgelegt ist, durch einen Hochversorgungsspannungsanschluss vorgespannt zu werden, und ein Low-Side-Versorgungseingang des ersten Latch-Inverters dazu ausgelegt ist, durch einen Niederversorgungsspannungsanschluss vorgespannt zu werden, um Leistung an den ersten Latch-Inverter zu liefern;
während der Latch-Phase ein High-Side-Versorgungseingang des zweiten Latch-Inverters dazu ausgelegt ist, durch den Hochversorgungsspannungsanschluss vorgespannt zu werden, und der Low-Side-Versorgungseingang des zweiten Latch-Inverters dazu ausgelegt ist, durch den Niederversorgungsspannungsanschluss vorgespannt zu werden, um Leistung an den zweiten Latch-Inverter zu liefern;
wobei während der Rücksetzphase und der Vorverstärkungsphase der High-Side-Versorgungseingang des ersten Latch-Inverters und der Low-Side-Versorgungseingang des ersten Latch-Inverters dazu ausgelegt sind, nicht vorgespannt zu sein;
wobei während der Rücksetzphase und der Vorverstärkungsphase der High-Side-Versorgungseingang des zweiten Latch-Inverters und der Low-Side-Versorgungseingang des zweiten Latch-Inverters dazu ausgelegt sind, nicht vorgespannt zu sein.

## Revendications

1. Circuit (101), comprenant :
un verrou (104), le verrou comprenant :
une première entrée (VL+) ;
une deuxième entrée (VL-) ;
une première sortie (VOUT+) ;
une deuxième sortie (VOUT-) ;
un premier ensemble d'un ou plusieurs inverseurs (183, 185) couplés à un chemin de signaux en série, une entrée de signal d'un premier inverseur en série (183) du premier ensemble étant connectée à la première entrée et une sortie de signal d'un dernier inverseur en série (185) du premier ensemble étant connectée à la première sortie, le premier inverseur en série du premier ensemble comportant une première entrée d'alimentation qui est configurée pour être polarisée par la deuxième entrée ;
un deuxième ensemble d'un ou plusieurs inverseurs (171, 173) couplés à un chemin de signaux en série, une entrée de signal d'un premier inverseur en série (171) du deuxième ensemble étant connectée à la deuxième entrée et une sortie de signal d'un dernier inverseur en série (173) du deuxième ensemble étant connectée à la deuxième sortie, le premier inverseur en série du deuxième ensemble comportant une première entrée d'alimentation qui est configurée pour être polarisée par la première entrée ;
où, pendant une phase de réinitialisation (PHR), la première sortie et la deuxième sortie sont configurées pour être réglées à un même état de valeur de sortie, et pendant une phase de verrouillage (PHL), la première sortie et la deuxième sortie sont configurées pour être verrouillées à des états de valeur de sortie complémentaires en fonction des tensions de la première entrée et de la deuxième entrée.

2. Circuit selon la revendication 1, dans lequel, pendant la phase de réinitialisation, la première entrée et la deuxième entrée sont configurées pour être égalisées en tension.

3. Circuit selon la revendication 2, dans lequel, pendant la phase de réinitialisation, la première entrée et la deuxième entrée sont configurées pour être égalisées à une tension en mode commun des tensions de la première entrée et de la deuxième entrée avant l'égalisation.

4. Circuit selon l'une quelconque des revendications précédentes, dans lequel le premier ensemble d'un ou plusieurs inverseurs comporte deux inverseurs ou plus et le deuxième ensemble d'un ou plusieurs inverseurs comporte deux inverseurs ou plus.

5. Circuit selon l'une quelconque des revendications précédentes, dans lequel :
le premier inverseur en série du premier ensemble et le premier inverseur en série du deuxième ensemble comportant chacun un transistor de type P couplé en série à un transistor de type N ;
pour le premier inverseur en série du premier ensemble, une première borne de courant de l'un du transistor de type P ou du transistor de type N est configurée pour être polarisée par la deuxième entrée, une première borne de courant de l'autre du transistor de type P ou du transistor de type N étant configurée pour être polarisée par une borne d'alimentation en tension ;
pour le premier inverseur en série du deuxième ensemble, une première borne de courant de l'un du transistor de type P ou du transistor de type N est configurée pour être polarisée par la première entrée, une première borne de courant de l'autre du transistor de type P ou du transistor de type N étant configurée pour être polarisée par la borne d'alimentation en tension.

6. Circuit selon la revendication 5, dans lequel :
pendant une phase de réinitialisation, la première entrée et la deuxième entrée sont configurées pour être égalisées en tension ;
pour le premier inverseur en série du premier ensemble, l'autre du transistor de type P ou du transistor de type N est conducteur lorsque la première entrée et la deuxième entrée sont égalisées en tension ;
pour le premier inverseur en série du deuxième ensemble, l'autre du transistor de type P ou du transistor de type N est conducteur lorsque la première entrée et la deuxième entrée sont égalisées en tension.

7. Circuit selon la revendication 5 ou 6, dans lequel :
pour le premier inverseur en série du premier ensemble et le premier inverseur en série du deuxième ensemble, le transistor de type P est un PFET et le transistor de type N est un NFET ;
pour le premier inverseur en série du premier ensemble, une borne de source du NFET est connectée à la deuxième entrée, et une borne de source du PFET est configurée pour être polarisée par une borne d'alimentation en tension haute ;
pour le premier inverseur en série du deuxième ensemble, une borne de source du NFET est connectée à la première entrée, et une borne de source du PFET est configurée pour être polarisée par la borne d'alimentation en tension haute.

8. Circuit selon la revendication 5 ou 6, dans lequel :
pour le premier inverseur en série du premier ensemble et le premier inverseur en série du deuxième ensemble, le transistor de type P est un PFET et le transistor de type N est un NFET ;
pour le premier inverseur en série du premier ensemble, une borne de source du PFET est connectée à la deuxième entrée, et une borne de source du NFET est configurée pour être polarisée par une borne d'alimentation en tension basse ;
pour le premier inverseur en série du deuxième ensemble, une borne de source du PFET est connectée à la première entrée, et une borne de source du NFET est configurée pour être polarisée par la borne d'alimentation en tension basse.

9. Circuit selon l'une quelconque des revendications précédentes, comprenant en outre :
un circuit de comparaison (101), le circuit de comparaison incluant le verrou et un circuit pré-amplificateur (103), le circuit pré-amplificateur comportant :
une première entrée (VIN+) ;
une deuxième entrée (VIN-) ;
une première sortie (VI+) couplée à la première entrée du verrou ;
une deuxième sortie (VI-) couplée à la deuxième entrée du verrou ;
la première sortie du verrou et la deuxième sortie du verrou étant verrouillées à des états de valeur de sortie complémentaires indicatifs d'une comparaison de tensions de la première entrée du pré-amplificateur et de la deuxième entrée du pré-amplificateur.

10. Circuit selon la revendication 9, dans lequel le pré-amplificateur comprend :
un premier inverseur auto-polarisé (125) comportant une entrée de signal et une sortie de signal connectées à une première sortie du pré-amplificateur ;
un deuxième inverseur auto-polarisé (127) comportant une entrée de signal et une sortie de signal connectées à la deuxième sortie du pré-amplificateur ;
où, pendant une phase de pré-amplification (PHPA) du circuit de comparaison, une entrée d'alimentation côté haut du premier inverseur auto-polarisé est configurée pour être polarisée par une borne de tension d'alimentation haute (VDD) et une entrée d'alimentation côté bas du premier inverseur auto-polarisé est configurée pour être polarisée par une borne de tension d'alimentation basse (VSS) ;
où, pendant la phase de pré-amplification, une entrée d'alimentation côté haut du deuxième inverseur auto-polarisé est configurée pour être polarisée par la borne de tension d'alimentation haute et une entrée d'alimentation côté bas du deuxième inverseur auto-polarisé est configurée pour être polarisée par la borne de tension d'alimentation basse ;
et pendant une phase de réinitialisation du circuit de comparaison, les entrées d'alimentation côté haut du premier inverseur auto-polarisé et du deuxième inverseur auto-polarisé ne sont pas configurées pour être polarisées par la borne de tension d'alimentation haute et les entrées d'alimentation basses du premier inverseur auto-polarisé et du deuxième inverseur auto-polarisé ne sont pas configurées pour être polarisées par la borne de tension d'alimentation basse.

11. Circuit selon la revendication 9, dans lequel :
la première sortie du pré-amplificateur est couplée à la première entrée du verrou par l'intermédiaire d'un premier interrupteur (153) et la deuxième sortie du pré-amplificateur est couplée à la deuxième entrée du verrou par l'intermédiaire d'un deuxième interrupteur (151) ;
où, pendant la phase de réinitialisation, le premier interrupteur et le deuxième interrupteur sont configurés pour être ouverts, et pendant une phase de pré-amplification, le premier interrupteur et le deuxième interrupteur sont configurés pour être fermés ;
où, pendant la phase de réinitialisation, la première sortie du pré-amplificateur et la deuxième sortie du pré-amplificateur sont configurées pour être égalisées, et pendant la phase de pré-amplification, la première sortie du pré-amplificateur et la deuxième sortie du pré-amplificateur ne sont pas égalisées.

12. Circuit selon la revendication 11, dans lequel, pendant la phase de pré-amplification, le pré-amplificateur est configuré pour être polarisé par une borne de tension d'alimentation haute et être polarisé par une borne de tension d'alimentation basse pour fournir de l'énergie aux circuits du pré-amplificateur, et pendant le mode réinitialisation, le pré-amplificateur est configuré pour ne pas être polarisé par la borne de tension d'alimentation haute et la borne de tension d'alimentation basse.

13. Circuit selon l'une quelconque des revendications 9 à 12, dans lequel le circuit de comparaison comprend en outre un deuxième verrou (104) comportant :
un premier inverseur de verrou (155) et un deuxième inverseur de verrou (157) configurés selon une configuration à couplage croisé ;
une entrée de signal du premier inverseur verrou étant couplée à la deuxième sortie du pré-amplificateur, à une sortie de signal du deuxième inverseur de verrou et à la deuxième entrée du verrou ;
une entrée de signal du deuxième inverseur de verrou étant couplée à la première sortie du pré-amplificateur, à la sortie de signal du premier inverseur verrou et à la première entrée du verrou.

14. Circuit selon la revendication 13, dans lequel :
l'entrée de signal du premier inverseur de verrou est couplée à la deuxième sortie du pré-amplificateur par l'intermédiaire d'un premier interrupteur ;
l'entrée de signal du deuxième inverseur de verrou est couplée à la première sortie du pré-amplificateur par l'intermédiaire d'un deuxième interrupteur ;
où, pendant la phase de réinitialisation, le premier interrupteur et le deuxième interrupteur sont ouverts ;
et pendant la phase de pré-amplification, le premier interrupteur et le deuxième interrupteur sont fermés.

15. Circuit selon la revendication 14, dans lequel :
pendant une phase de verrouillage, une entrée d'alimentation côté haut du premier inverseur de verrou est configurée pour être polarisée par la borne de tension d'alimentation haute et une entrée d'alimentation côté bas du premier inverseur de verrou est configurée pour être polarisée par une borne de tension d'alimentation basse pour fournir de l'énergie au premier inverseur de verrou ;
pendant la phase de verrouillage, une entrée d'alimentation côté haut du deuxième inverseur de verrou est configurée pour être polarisée par la borne de tension d'alimentation haute et l'entrée d'alimentation côté bas du deuxième inverseur de verrou est configurée pour être polarisée par la borne de tension d'alimentation basse pour fournir de l'énergie au deuxième inverseur de verrou ;
pendant la phase de réinitialisation et la phase de pré-amplification, l'entrée d'alimentation côté haut du premier inverseur de verrou et l'entrée d'alimentation côté bas du premier inverseur de verrou sont configurées pour être non-polarisées ;
pendant la phase de réinitialisation et la phase de pré-amplification, l'entrée d'alimentation côté haut du deuxième inverseur de verrou et l'entrée d'alimentation côté bas du deuxième inverseur de verrou sont configurées pour être non-polarisées.
